Europäisches Patentamt

European Patent Office

Office européen des brevets

(19)

(11) Publication number : **0 520 841 A1**

## (12) EUROPEAN PATENT APPLICATION

(21) Application number : **92305999.2**

(22) Date of filing : **29.06.92**

(51) Int. Cl.⁵ : **H01L 21/66, H01L 21/60, H01L 23/498**

(30) Priority : **27.06.91 US 722449**
**27.06.91 US 722429**

(43) Date of publication of application :
**30.12.92 Bulletin 92/53**

(84) Designated Contracting States :
**DE FR GB IT**

(71) Applicant : **MOTOROLA, INC.**
**1303 East Algonquin Road**
**Schaumburg, IL 60196 (US)**

(72) Inventor : **Lin, Paul T.**
**6411 Cerro Cove**
**Austin, Texas 78731 (US)**

(74) Representative : **Dunlop, Hugh Christopher et al**
**Motorola European Intellectual Property Operations Jays Close Viables Industrial Estate**
**Basingstoke, Hampshire RG22 4PD (GB)**

(54) **Composite flip chip semi-conductor device and method for making and burning-in the same.**

(57) A process for enhancing burn-in of composite flip chip semiconductor devices allows for simultaneous burn-in of a plurality of devices without the need for individual test sockets. In one form, the process includes providing an interposer substrate material (60) having a plurality of die receiving areas, represented as interposers (22). A plurality of conductive traces (26) on the interposer substrate material is electrically coupled to a plurality of electrical vias (24) which extend from a first surface of the interposer substrate material to a second surface. A semiconductor die (12) is positioned in each of the die receiving areas, i.e. on each interposer, such that the die is electrically coupled to the plurality of vias (24). The semiconductor die are burned-in by subjecting the interposer substrate material to predetermined stresses. The interposer substrate material is singulated to separate the die receiving areas and form a plurality of composite flip chip semiconductor devices (10).

FIG.5

EP 0 520 841 A1

## Field of the Invention

The present invention is related to semiconductor devices in general, and more specifically to flip chip semiconductor devices and methods for making and burning-in the same.

## Background of the Invention

A flip chip semiconductor device refers to a packageless semiconductor device which is used for mounting to a substrate, such as a printed circuit (PC) board, in a die-down or chip-down position. In other words, an active surface of a semiconductor die which is a component of the device will be facing the substrate. Typically, a flip chip device is mounted to a substrate by forming a plurality of conductive bumps, for example solder bumps, on an active surface of a semiconductor die and electrically coupling these bumps to a corresponding pattern of electrical terminals on a substrate. A common method of coupling the bumps to the terminals is by positioning the active surface of the die adjacent a surface of the substrate such that the bumps align with the electrical terminals. The die and substrate are subjected to a heated environment such that the bump material begins to soften or flow, thereby wetting the electrical terminals. Upon cooling, the bump material hardens and forms a metallurgical bond between the bump on the die and the electrical terminal on the substrate. Flip chip die can also be electrically coupled to a substrate using a combination of solder bumps and solder balls with varying compositions in order to achieve eutectic solder joints.

An advantage in using flip chip technology is that device size can be kept to a minimum since the device does not employ a traditional package body. Furthermore, electrical connections between a semiconductor die and a substrate are confined to an area of the substrate which does not exceed the size of the die. There is no need for wire bonds or for any kind of external lead in order to couple the die to the substrate.

However, a substantial disadvantage in using flip chip technology is that there is not a manufacturable method of burning-in flip chip devices, primarily because such devices lack external leads. Burn-in refers to tests which many semiconductor manufacturers use to screen weak devices before shipping the devices to customers. A common burn-in procedure is to operate the devices at elevated temperatures and high voltages to detect early device failures. Because the devices are being operated during burn-in, the device must be electrically coupled to burn-in testing equipment. A widely accepted burn-in set-up involves affixing a plurality of similar semiconductor devices to a burn-in test board, usually by placing each device in a pre-established test socket which is attached to the board. The board is then electrically connected to the test equipment such that a plurality of devices can be burned-in simultaneously. Flip chip semiconductor devices are not able to be burned-in according to the above procedure because flip chip devices cannot be used in existing test sockets. Conventional test sockets are designed to accommodate external device leads which flip chip devices lack. Most flip chip devices have solder bumps on the active surface of the die so that ordinary test sockets cannot be used for burn-in testing of the devices. For this reason, many manufacturers have chosen not to perform burn-in testing on flip chip devices. As a result, some defective flip chip devices which would otherwise be identified as early failures during burn-in are being sent to customers.

Another disadvantage in using existing flip chip technology is that conductive bumps formed on an active surface of a semiconductor die often require an additional level of metallization to be formed on the die. After forming metallized bonding pads on the die, an additional metal layer is usually deposited and patterned in order to transform the bond pad configuration into a configuration which will match a substrate's electrical terminal configuration. In addition to processing steps related to the extra metal layer, flip chip devices also require at least one additional insulating layer and several masking operations. Adding processing steps in die fabrication increases the probability of creating a defect, thereby lowering device yield. Not only does the additional metal layer adversely impact device fabrication, but the presence of an additional metal layer may increase device capacitance which is undesirable.

Yet another disadvantage associated with flip chip technology is that the ability to perform rework on a device is often restricted. Upon mounting a flip chip device to a substrate, such as a PC board, many device users underfill the mounted device, or in other words fill the space between a semiconductor die and the substrate. Thermally conductive epoxy is one material of choice for flip chip underfill. The purpose in underfilling flip chip devices is to constrain the expansion and contraction of the semiconductor die with respect to the substrate. In general, a semiconductor die has a coefficient of thermal expansion which is quite different than a coefficient of the thermal expansion for the substrate. As a result, the die will expand and contract at a different rate than will the substrate, creating stress on solder joints and a potential for the electrical connections between the die bonding pads and the substrate terminal pads to become open. The use of an underfill material helps to constrain the expansion and contraction of the die, thereby reducing the potential for open connections. However, the use of an underfill material also prohibits rework. If an underfill material is used, it is not possible to remove a defective semiconductor device from a substrate and replace the defective part with a functional part because the underfill material is typically a thermosetting material, i.e. one which is permanently rigid and cannot be softened or flowed.

Because existing technology has the disadvantages set forth above, a need exists for an improved semiconductor device, and more specifically for an improved flip chip semiconductor device and method for making the same which can be burned-in in a manner which is suitable for a manufacturing environment, which does not require a semiconductor die to have an additional layer of metallization beyond the metallization used for internal circuitry, and which has the ability to be reworked without compromising thermal and mechanical performance. Furthermore, it is desirable for such a device to be able to be fabricated cost-effectively.

Summary of the Invention

The foregoing need is met and other advantages are achieved with the present invention. In one embodiment, a process for enhancing burn-in of composite flip chip semiconductor devices comprises providing an interposer material having a plurality of die receiving areas and having first and second surfaces. The first surface of the interposer material has a plurality of conductive traces which is electrically coupled to a plurality of electrical vias that extends from the first surface of the interposer material to the second surface. A semiconductor die is positioned in each of the die receiving areas such that the semiconductor die is electrically coupled to the plurality of vias. The semiconductor die are burned-in by subjecting the interposer material to predetermined stresses. The interposer material is singulated to separate the die receiving areas and form a plurality of composite flip chip semiconductor devices.

These and other features, and advantages, will be more clearly understood from the following detailed description taken in conjunction with the accompanying drawings. It is important to note the drawings may not be drawn to scale, but are illustrated to clearly point out various features of the present invention. The specific embodiments and features illustrated are not intended to limit the scope of the invention.

Brief Description of the Drawings

FIG. 1 is a perspective view of a semiconductor die which is to be attached to an interposer in accordance with the present invention to form a composite flip chip semiconductor device.

FIG. 2 is a top view of the semiconductor device of FIG. 1 after the semiconductor die has been positioned on the interposer.

FIG. 3 is a bottom view of the semiconductor device of FIG 2.

FIG. 4 is a cross-sectional view of the semiconductor device of FIG. 2 taken along the line 4-4.

FIG. 5 is a cross-sectional view of the semiconductor device of FIG. 2 taken along the line 5-5.

FIG. 6 is a top view of an interposer substrate material used in accordance with the present invention.

FIG. 7 is a bottom view of an interposer of a composite flip chip semiconductor device also in accordance with another form of the present invention.

Detailed Description of a Preferred Embodiment

Although flip chip semiconductor devices have a significant advantage in that the devices are very small, flip chip devices also have several disadvantages. As mentioned in the background discussion, flip chip devices are unable to be burned-in using existing testing equipment, require additional metallization layers and die fabrication steps which potentially degrade device yield, and cannot be reworked once attached to a substrate using an underfill material. The present invention overcomes each of the above drawbacks of existing flip chip devices in addition to having other advantages which will become apparent throughout the discussion. The present invention utilizes an interposer which is coupled to an active surface of a semiconductor die. The interposer has a metallization layer formed on at least one side, thereby eliminating the need for an additional metallization layer on the semiconductor die. Furthermore, the interposer can be designed to include test contacts which permit the composite semiconductor device to be burned-in individually using a test socket or simply by contacting either top-side or edge test contacts. As a low-cost method of burning-in devices formed in accordance with the present invention, a plurality of interposers can be formed on a single interposer substrate, functioning as a burn-in board, which permits several devices to be burned-in simultaneously. Another advantage of the present invention is that the interposer can be of a material which enhances thermal and mechanical performance of the device without restricting the ability to perform rework. Because the interposer is to be attached to a substrate, as opposed to the semiconductor die being attached to the substrate, an underfill material between the interposer and the substrate will not prevent the semiconductor die from being removed. Thus a defective semiconductor die can be replaced with a functional die even after the flip chip device has been mounted to a substrate.

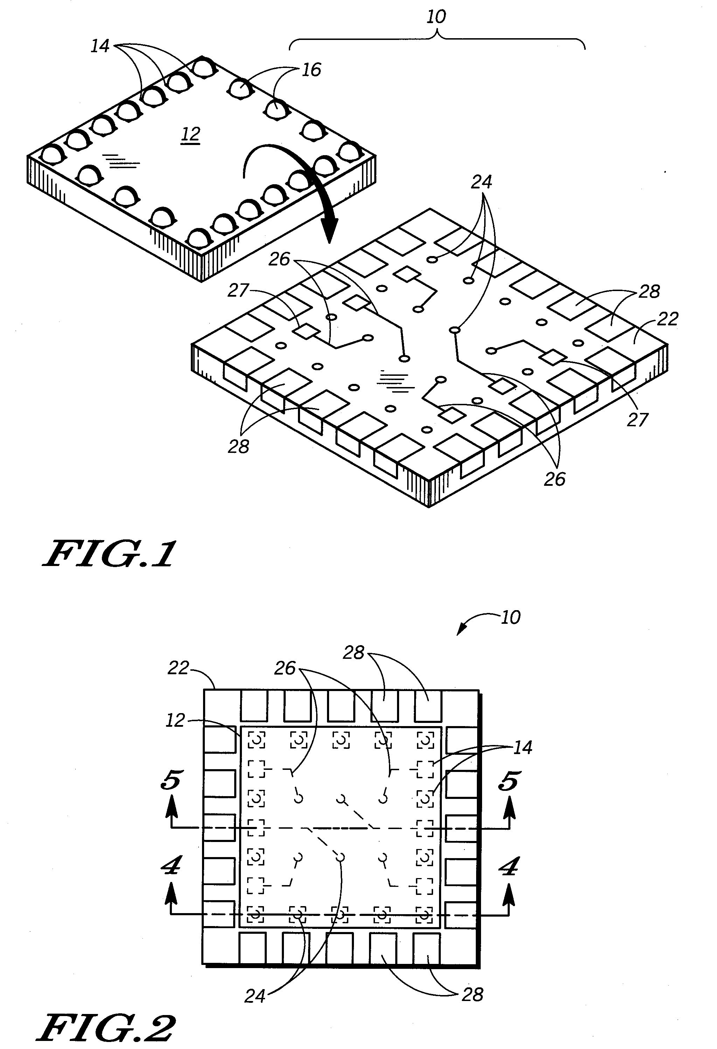

FIG. 1 illustrates a perspective view of a composite flip chip semiconductor device 10 in accordance with the present invention. The device includes a semiconductor die 12 having a plurality of bonding pads 14 formed on a.top surface thereof. Bonding pads 14 are electrically coupled in a conventional form to an integrated circuit (not shown) which is also formed on the top surface of the die. Bonding pads 14 are typically formed along the periphery of the semiconductor die, as illustrated, in order to maximize the number of bonding pads per die without interfering in the layout of the integrated circuit. Formed on each of the bonding pads 14 is a solder bump 16. Solder bumps are well known in the art as a method of coupling a flip chip semiconductor die to a substrate (not shown).

In conventional flip chip devices, a layer of metal is often formed on the semiconductor die, making electrical connection to the bonding pads, in order to transpose the peripheral bonding pad configuration to an array configuration. An array configuration of bonding pads and solder bumps is often necessary to correspond with an array of electrical terminals on a PC board or multi-layer ceramic substrate. As mentioned earlier, the additional layer of metal increases the number of processing steps required in die fabrication and can potentially reduce device yield. The present invention does not require an additional layer of metallization on the semiconductor die to transform the peripheral solder bumps into an array configuration. Instead, the present invention incorporates a rigid interposer 22, as illustrated in FIG. 1, to achieve a desired terminal configuration. Semiconductor die 12 is attached to interposer 22 such that solder bumps 16 align to, and are in electrical contact with, a plurality of electrical vias 24 provided in the interposer. The vias may be conveniently formed in a configuration which will match an electrical terminal . configuration of a substrate (not shown). For those solder bumps which do not align directly with a via upon positioning the die on the interposer, a plurality of conductive traces 26 are provided on the interposer to electrically route the solder bump to a particular via location. As illustrated, some of the solder bumps 16 are to be coupled to terminal pads 27 formed at an end of the conductive traces rather than directly connected to vias. The conductive traces are routed to the appropriate vias. FIG. 2 illustrates a top view of semiconductor die 12 and interposer 22 after the die has been positioned on the interposer.

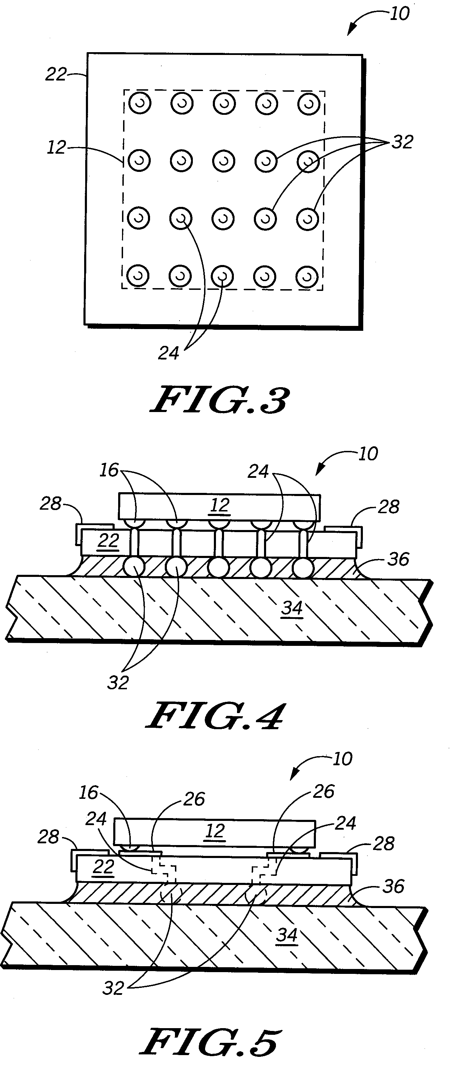

Electrical vias 24 extend from a top surface of interposer 22 to a bottom surface where a plurality of solder balls are formed. FIG. 3 illustrates a configuration of solder balls 32 which correspond with the electrical via configuration of interposer 22. The solder balls also correspond with an electrical terminal configuration of a substrate (not shown). Although each solder ball is illustrated as being positioned directly under a via, conductive traces may also be formed on the bottom surface of the interposer to electrically route the vias to the solder bumps. In other words, solder balls 32 may be offset from vias 24, similar to the way in which some of solder bumps 16 are offset from, and electrically routed to, vias 24 in FIG. 1.

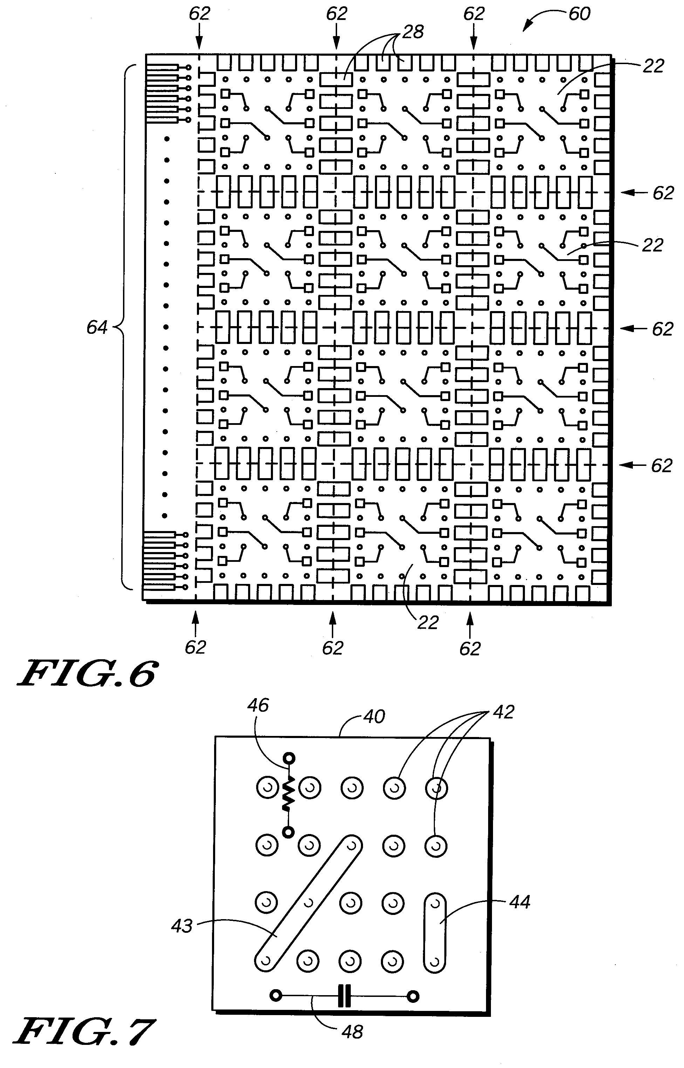

For a better understanding of a device application, composite flip chip semiconductor device 10 is illustrated in cross-section in FIGs. 4 and 5 as the device might be mounted on a PC board. FIG 4 is a cross-sectional view of the device taken along the line 4-4 of FIG. 2, while FIG. 5 is a cross-sectional view taken along the line 5-5. In FIG. 4, semiconductor die 12 is coupled to interposer 22 such that solder bumps 16 coincide with vias 24. Beneath each via is a solder ball 32 which in turn is coupled to a substrate such as PC board 34. While die 12 and interposer 22 are essentially separated by air, interposer 22 and PC board 34 are separated by an underfill material 36. As discussed in the background, underfill materials are commonly used between a flip chip semiconductor die and a substrate in order to restrict the thermal expansion and contraction of the die relative to the substrate. However, the use of an underfill material in conventional flip chip devices prevents rework since the underfill materials commonly used, for example thermally conductive epoxies, cannot be reflowed. In an embodiment of the present invention, an underfill material can be used between interposer 22 and PC board 34. Once attached to PC board 34, interposer 22 cannot be removed; however, semiconductor die 12 can easily be removed from the interposer should any rework be necessary simply by heating and flowing solder bumps 16.

FIG. 5 demonstrates how conductive traces 26 can be used to "fan-in" peripheral solder bumps 16 to a predetermined via or solder ball configuration. Solder bumps 16 around the periphery of die 12 are connected to the terminal pads of conductive traces 26 which electrically route the solder bumps to vias 24. The via configuration is an array configuration, as evident in FIG. 1. Vias 24 are not in the plane of the cross-sectional view of FIG. 5 and are thus shown as being hidden. Since the conductive traces 26 of the interposer can be used to fan-in peripheral solder bumps to an array configuration, semiconductor die 12 can be used not only as a flip chip semiconductor die, but alternatively as a conventional wire-bonded or TAB (tape automated bonding) die which typically requires peripheral bonding sites. Therefore, semiconductor die fabrication becomes a standardized process for either flip chip, wire bonded, or TAB devices.

FIG. 5 also demonstrates that vias 24 need not be completely vertical as illustrated in FIG. 4, but may instead be kinked or otherwise slanted. Having the vias kinked requires interposer 22 to be a multi-layer material having more than one conductive layer. The use of a multi-layer interposer provides more flexibility in arranging vias and solder balls while also increasing the number of possible via and solder ball locations since metallization is not restricted to one layer.

There is also an advantage in using only one conductive layer in interposer 22 which relates to ease of manufacturing. By using only one conductive layer, namely a conductive layer on the top of the interposer, vias and solder balls of the interposer can be formed in a predetermined, fixed configuration which is a standard to several different semiconductor die. For example, in reference to FIG. 1, semiconductor die 12 has twenty bonding pads which respectively correspond to twenty vias on interposer 22. The vias are arranged in a regular array which might match a standardized electrical terminal configuration of a substrate (not shown). Numerous types of semiconductor die may have twenty bonding pads, but the bonding pads may not be located precisely in the same locations from die to die. However, interposer 22 can be used for each of the different die having twenty bonding pads simply by changing the metallization pattern which forms conductive traces 26. In other words, one metal layer can be changed to accommodate various bonding pad configurations while the via and solder ball configuration can remain fixed. While an interposer having multiple metal layers can also be used for each of the different bonding pad configurations, more than one of the metal layers will most likely have to be "customized" to accommodate each configuration, thereby increasing the number of manufacturing steps.

In making an interposer which is suitable for use in the present invention, a preferred material is one that has a coefficient of thermal expansion (CTE) which closely approximates that of a semiconductor die. Semiconductor die are, for the most part, formed of silicon which has a CTE of approximately 3 ppm (parts per million)/°C. Therefore, a preferred material for an interposer would be silicon since the CTE of the interposer would match that of the die. However, other materials have a CTE close to the CTE of silicon, for example the CTE of aluminum nitride is on the order of 4.5 ppm/°C. Other ceramics may also be suitable for use as the interposer material. In having the CTE of the interposer and die closely matched, there is a reduced chance that the electrical bonds between the solder bumps and the conductive traces or vias will be broken as a result of thermally induced stress. Furthermore, the closely matched CTEs of the die and the interposer permit the use of rigid joints to couple the die and interposer. Solder is the most common material used to couple flip chip die to any kind of substrate because solder is considered to be a flexible joint which helps to absorb thermally induced stresses. By having the CTE of the interposer closely match that of the semiconductor die, one may instead choose to use a rigid coupling joint, for example a copper joint, for improved electrical performance. Another consideration in choosing a material for the interposer is thermal dissipation. Many semiconductor devices generate a great deal of heat during operation. Using an interposer material with good thermal dissipation properties will help remove heat from a composite flip chip device, thereby increasing device lifetime and improving reliability.

In making an interposer, such as interposer 22, vias and conductive traces can be formed on the interposer using known techniques. For example, screen printing or metal deposition and etching techniques can be used to form conductive traces, while etching or laser drilling can be used to form the vias. The vias must be electrically conductive and therefore will be filled with a conductive material.

Apart from the benefit of providing rework capabilities and improving resistance to thermally induced stress, the use of an interposer in accordance with the present invention also establishes a method of testing and burning-in a flip chip semiconductor device. For instance, interposer 22 of FIG. 1 is provided with a plurality of test contacts 28 located around the interposer periphery. Test contacts 28 may also extend along the sides of the interposer, as illustrated, or may be formed only on the top surface of the interposer. Test contacts are electrically coupled to the solder bumps of die 12 by having the contacts coupled to the vias as discussed below. It should, however, be noted that there need not be a one-to-one correspondence between the test contacts and the vias, depending on the extent of testing to be performed. The electrical connection between the test contacts and the vias is not illustrated for sake of clarity; however, connections between the test contact and the vias can easily be made by at least two methods. One method is to utilize a multi-layer interposer that includes a conductive layer dedicated to coupling the test contacts to the vias. Another method is to form a second plurality of conductive traces on the interposer's top surface to perform the same function. The presence of test contacts 28 permit the use of conventional probe needles (not shown) to test the functionality of the die. Furthermore, having test contacts 28 extend at least partially along a side of the interposer allows the composite flip chip semiconductor device to be tested and burned-in in a known test socket which is capable of handling edge contacts.

An interposer in a composite flip chip semiconductor device, in accordance with the present invention, creates a feasible way of burning-in individual devices. Moreover, there is a low-cost method of producing interposers such that a plurality of devices can be burned-in simultaneously much like existing burn-in board schemes. Illustrated in FIG. 6 is an interposer substrate 60 which includes a plurality of interposers 22. The interposers are separated from one another by perforations 62 formed in the interposer substrate. Along a side of the interposer substrate is a plurality of substrate test contacts 64 which is electrically coupled to the individual interposers 22 as discussed below; however, the electrical connections are not illustrated in FIG. 6. A substrate test contact for each individual interposer via is usually not required since certain connections can be done in series. Use of a multi-layer interposer substrate can be used to make the connections from the substrate test contacts to the individual interposer vias. A single layer interposer substrate may be used instead; however, use of a single layer substrate may require the area of the substrate to be increased in order to accommodate the conductive wiring on one level.

After coupling a semiconductor die (not shown in FIG. 6) to each of the individual interposers, the interposer substrate functions similar to a conventional burn-in board. Electrical connectors of burn-in equipment are connected to the substrate test contacts 64 to test or stress a plurality of individual semiconductor die simultaneously. Burning-in an entire interposer substrate has advantages over individual device burn-in since the time required to burn-in a large number of devices is reduced if done simultaneously and since test sockets for each device are not necessary. If burn-in is performed at the interposer substrate level rather than at the individual device level, it is not necessary to include test contacts 28 on the individual interposers. Once burn-in testing has been accomplished at the interposer substrate level, the individual interposers 22 are singulated, for example by cutting or breaking the interposer substrate 60 along perforations 62. The result of singulating the interposers is a plurality of composite flip chip semiconductor devices such as that illustrated in FIGs. 1-5.

Yet another advantage provided by an interposer used in accordance with the present invention is an enhancement in electrical performance of a flip chip semiconductor device. Use of an interposer creates two additional surfaces on which circuitry or electrical components can be formed. For example, FIG. 7 illustrates a bottom surface of an interposer 40 which is suitable for use in the present invention. In addition to a plurality of solder balls 42 which are similar to those of the previously described embodiment of the invention, interposer 40 also includes two electrical components, namely a terminal resistor 46 and a decoupling capacitor 48. The area of the interposer not occupied by solder balls, vias, or conductive traces is available for use for electrical components or may be used for additional power bussing. Therefore, additional circuitry, bussing, or components can be added to a semiconductor device without increasing the size of a flip chip semiconductor die. FIG. 7 also illustrates that common output signals from a device can be coupled together on the bottom of the interposer. For example, terminal groupings 43 and 44 can be used in place of a plurality of solder balls to couple, for example, POWER or GROUND outputs.

The foregoing description and illustrations contained herein demonstrate many of the advantages associated with the present invention. In particular, it has been revealed that a device in accordance with the present invention can be individually burned-in by providing test contacts on an interposer which is coupled to a flip chip semiconductor die. The test contacts can be formed so that the contacts are compatible with a test socket or so that the contacts can be tested with conventional probe needles. Moreover, an interposer substrate can be used to burn-in a plurality of flip chip devices simultaneously, much like conventional burn-in boards but without the need for test sockets. The present invention also eliminates the need for an additional metallization layer on a flip chip semiconductor die. Thus, die fabrication becomes less complicated with potentially higher yields in comparison to existing flip chip fabrication techniques. The additional metal layer is instead formed on an interposer, which is a much more simple fabrication than having to add the metal layer to a die. In addition, eliminating the additional metallization layer makes flip chip semiconductor die compatible for use as wire-bonded or TAB bonded die. Yet another advantage is that an interposer can be used to reduce thermally induced stress in flip chip bonds and can be used to dissipate heat during device operation by choosing an appropriate interposer material. Furthermore, the use of an interposer in a flip chip semiconductor device establishes additional surfaces on which to form circuitry, buses, or other electrical components without having to increase the area of a semiconductor die.

Thus it is apparent that there has been provided, in accordance with the invention, a process for enhancing burn-in of composite flip chip semiconductor devices that fully meets the need and advantages set forth previously. Although the invention has been described and illustrated with reference to specific embodiments thereof, it is not intended that the invention be limited to these illustrative embodiments. Those skilled in the art will recognize that modifications and variations can be made without departing from the spirit of the invention. For example, an interposer used the invention need not be made of silicon or aluminum nitride, instead may be of any material. However, a preferred interposer material is one which has a CTE which is similar to the CTE for the Semiconductor die used in the inventive device. In addition, the invention is not limited to use of an interposer which transforms a peripheral bonding pad configuration into an array configuration. Many of the advantages set forth above may be achieved regardless of the configuration of electrical connections. It is also important to note that the present invention is not limited in any way to the use of solder bumps on a semiconductor die. Any method of electrically coupling a semiconductor die to an interposer is within the scope of the present invention. Similarly, methods other than solder balls are suitable for coupling an interposer to a substrate. Also, an interposer need not have test contacts in order to be beneficial, although test contacts permit individual device testing and burn-in. Furthermore, an interposer used in accordance with the present invention need not be larger than a flip chip semiconductor die, as the drawings indicated. However, having the interposer larger than the die establishes more flexibility in testing and burning-in the flip chip device. Additionally, an interposer used in conjunction with the invention is not limited to having conductive traces on a top surface which is opposite a semiconductor die. A bottom surface of the interposer, which would be opposite a substrate, may also include a plurality of conductive traces to route a plurality of vias into a desired configuration. Likewise, an interposer substrate material used in accordance with the invention may be of a single-layer or multi-layer material. It should also be noted that circuitry, buses, and electrical components other than those types specifically described or illustrated can also be formed on an interposer surface to enhance or assist in electrical device performance. Moreover, the invention is in no way restricted to use of a particular type of semiconductor die in the device. Therefore, it is intended that this invention encompass all such variations and modifications as fall within the scope of the appended claims.

**Claims**

1. A composite flip chip semiconductor device (10) comprising:

a single semiconductor die (12) having an integrated circuit formed thereon and a plurality of bonding pads (14) electrically coupled to the integrated circuit;

an interposer (22) having first and second surfaces and a plurality of vias (24) extending from the first surface to the second surface, the first surface having a plurality of conductive traces (26) electrically coupled to the plurality of vias;

means for electrically coupling the plurality of bonding pads to the plurality of conductive traces; and

means for electrically coupling the plurality of vias to a substrate.

2. The semiconductor device of claim 1 further comprising a plurality of test contacts (28) formed on the first surface of the interposer, the plurality of test contacts being electrically coupled to the plurality of bonding pads.

3. The semiconductor device of claim 1 or 2 wherein the interposer is comprised of a material having a coefficient of thermal expansion which is substantially equal to a coefficient of thermal expansion of the semiconductor die

4. The semiconductor device of claim 1, 2 or 3 wherein the semiconductor die (12) and interposer (22) are separated in part by air.

5. A method of making a composite flip chip semiconductor device (10), comprising the steps of;

providing a semiconductor die (12) having first and second opposing surfaces and an integrated circuit formed thereon, the first surface having a plurality of bonding pads (14) which are electrically coupled to the integrated circuit;

providing an interposer (22) having first and second opposing surfaces and having a plurality of electrical vias (24) which extend from the first surface to the second surface, the first surface having a plurality conductive traces (26) which are electrically coupled to the plurality of vias;

attaching the semiconductor die to the interposer such that the first surface of the semiconductor die opposes the first surface of the interposer and such that the plurality of bonding pads are electrically coupled to the plurality of vias; and

providing means to electrically couple the plurality of vias to a substrate.

6. A process for enhancing burn-in of composite flip chip semiconductor devices comprising the steps of:

providing an interposer substrate material (60) having a plurality of die receiving areas (22) and having first and second surfaces, the first surface having a plurality of conductive traces (26) electrically coupled to a plurality of electrical vias (24) which extend from the first surface to the second surface;

positioning a semiconductor die (12) in each of the die receiving areas such that the semiconductor die is electrically coupled to the plurality of vias;

burning-in each of the semiconductor die by subjecting the interposer substrate material to predetermined stresses; and

singulating the interposer substrate material to separate the die receiving areas and form a plurality of composite flip chip semiconductor devices (10).

7. The process of claim 6 wherein the step of providing an interposer substrate material comprises providing an interposer substrate material having a plurality of substrate test contacts (28) which are electrically coupled to the plurality of vias.

8. The process of claim 5 or 7 wherein the step of providing an interposer substrate material comprises providing a rigid interposer substrate material having a coefficient of thermal expansion which is substantially equal to a coefficient of thermal expansion of the semiconductor die.

*FIG.1*

*FIG.2*

*FIG.3*

*FIG.4*

*FIG.5*

**FIG.6**

**FIG.7**

**European Patent Office**

# EUROPEAN SEARCH REPORT

Application Number

EP    92 30 5999

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | IBM TECHNICAL DISCLOSURE BULLETIN. vol. 32, no. 8A, January 1990, NEW YORK US pages 178 - 179; 'LSI packaging design' * the whole document * | 1,3-5 | H01L21/66 H01L21/60 H01L23/498 |
| Y | | 2,6-8 | |
| Y | PATENT ABSTRACTS OF JAPAN vol. 11, no. 104 (E-494)2 April 1987 & JP-A-61 253 839 ( HITACHI ) 11 November 1986 * abstract * | 2,6-8 | |
| X | EP-A-0 351 581 (CONTRAVES) * column 8, line 37 - column 9, line 53; figures 3A-3F,5 * | 1,3-5 | |
| Y | | 2,6-8 | |
| Y | PATENT ABSTRACTS OF JAPAN vol. 13, no. 304 (E-786)12 July 1989 & JP-A-1 081 333 ( HITACHI ) 27 March 1989 * abstract * | 2,6-8 | |

TECHNICAL FIELDS SEARCHED (Int. Cl.5)

H01L
H01R
G01R

The present search report has been drawn up for all claims

| Place of search | Date of completion of the search | Examiner |
|---|---|---|
| BERLIN | 14 SEPTEMBER 1992 | LE MINH I. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)